# FASCICULE DE BREVET EUROPEEN

(11) **EP 4 492 471 B1**
(45) Date de publication et mention de la délivrance du brevet: **25.03.2026**
(21) Numéro de dépôt: 24187074.0
(22) Date de dépôt: 08.07.2024
(51) Int. Cl.: H10D 30/60, H01L 21/265, H01L 21/268, H01L 21/324

(54) **PROCÉDÉ DE RÉALISATION D'UN ÉTAT DE CONTRAINTE DANS UNE COUCHE SEMI-CONDUCTRICE**
VERFAHREN ZUR ERZEUGUNG EINES SPANNUNGSZUSTANDS IN EINER HALBLEITERSCHICHT
METHOD FOR PRODUCING A STRESS STATE IN A SEMICONDUCTOR LAYER

(30) Priorité: 12.07.2023 FR 2307488
(43) Date de publication de la demande: 15.01.2025
(73) Titulaire: Commissariat à l'Energie Atomique et aux Energies Alternatives, 75015 Paris (FR)
(72) Inventeur: AUGENDRE, Emmanuel, 38054 Grenoble Cedex 09 (FR); ACOSTA ALBA, Pablo, 38054 Grenoble Cedex 09 (FR); REBOH, Shay, 38054 Grenoble Cedex 09 (FR); ROZEAU, Olivier, 38054 Grenoble Cedex 09 (FR)
(74) Mandataire: Hautier IP

(56) Documents cités:
- FR-A1- 3 120 738
- US-A1- 2023 093 111

## Description

### DOMAINE TECHNIQUE

La présente invention se rapporte au domaine de la microélectronique et, plus particulièrement, à celui des procédés permettant de déformer ou contraindre mécaniquement une couche semi-conductrice. Une application particulière concerne la réalisation de transistors Complémentaires Métal-Oxyde-Semiconducteur CMOS (acronyme de « Complementary Metal-Oxide-Semiconductor ») sur un substrat de type silicium sur isolant totalement déplété FDSOI (acronyme de « Fully Depleted Silicon On Insulator »).

### ETAT DE LA TECHNIQUE

Dans ce domaine, il est désirable d'augmenter la mobilité des porteurs de charge pour atteindre les meilleurs compromis entre performance et consommation énergétique.

La mobilité des électrons peut typiquement être augmentée (respectivement diminuée) par une contrainte mécanique en tension (respectivement en compression) du matériau semi-conducteur dans lequel ils transitent, alors que la mobilité des trous peut inversement être augmentée (respectivement diminuée) lorsque le semi-conducteur est en compression (respectivement en tension).

Ainsi, pour améliorer les performances des transistors, on peut prévoir de réaliser leur région de canal dans un matériau semi-conducteur ayant une contrainte mécanique en tension ou en compression. Typiquement, pour des transistors dont le canal est en silicium et de type N (les porteurs majoritaires sont des électrons), les configurations les plus favorables sont un canal en traction biaxiale ou en traction uniaxiale suivant la direction du transport électronique si la contrainte uniaxiale est supérieure ou égale à 1,4 GPa. Pour des transistors dont le canal est en silicium-germanium et de type P (les porteurs majoritaires sont des trous), la configuration la plus favorable est un canal en compression uniaxiale suivant la direction du transport électronique.

Le document FR3120738 A1 divulgue une méthode indirecte permettant de modifier un état de contrainte d'une couche semi-conductrice. Cette méthode est basée sur l'utilisation d'une couche fusible intercalée entre la couche semi-conductrice à déformer et le support. Une couche donneuse de contrainte est par ailleurs déposée sur la couche semi-conductrice à déformer. Un traitement thermique est ensuite effectué pour fondre la couche fusible. La couche donneuse de contrainte impose alors une déformation biaxiale à la couche semi-conductrice. Cette déformation biaxiale de la couche semi-conductrice demeure après solidification de la couche fusible et retrait de la couche donneuse de contrainte. Pour obtenir une contrainte uniaxiale, la couche semi-conductrice est ensuite typiquement découpée en bandes de façon à ce que la contrainte relaxe selon la largeur des bandes. Seule la contrainte selon la longueur des bandes subsiste.

Ce découpage en bandes consomme de la matière. Cette perte de matière se traduit par une densité d'intégration réduite.

Un objectif de la présente invention est de pallier les limitations de ce procédé connu.

**En** particulier, un objet de la présente invention est de proposer un procédé de réalisation d'un état de contrainte uniaxiale dans une couche semi-conductrice, permettant une densité d'intégration plus élevée.

### RESUME

Pour atteindre cet objectif, selon un mode de réalisation, on prévoit un procédé de réalisation d'un état de contrainte uniaxiale dans une couche semi-conductrice, ledit procédé comprenant au moins :
- Une fourniture d'un empilement comprenant un support, la couche semi-conductrice et une couche dite fusible intercalée entre le support et la couche semi-conductrice,
- Une formation d'une couche donneuse de contrainte sur la couche semi-conductrice,
- Une définition de motifs après formation de la couche donneuse de contrainte,
- Une formation, à partir desdits motifs, de régions entourées par des tranchées s'étendant jusque dans la couche semi-conductrice,
- Une altération partielle de la couche donneuse de contrainte au niveau desdites régions, configurée pour modifier un premier état de contrainte de ladite couche donneuse de contrainte de façon à obtenir un deuxième état de contrainte principalement selon une direction déterminée,
- Une fusion au moins partielle de la couche fusible, de façon à ce que la couche donneuse de contrainte transfère au moins en partie, par relaxation, le deuxième état de contrainte dans la couche semi-conductrice, de sorte à ce que la couche semi-conductrice présente un état de contrainte uniaxiale selon ladite direction déterminée.

Ainsi, contrairement au procédé connu mentionné plus haut, la transformation d'un état de contrainte initial, en l'espèce le premier état de contrainte, qui est typiquement un état de contrainte biaxiale, en un état de contrainte uniaxiale, en l'espèce le deuxième état de contrainte, se fait préalablement à la fusion de la couche fusible, en amont du transfert de l'état de contrainte dans la couche semi-conductrice. L'état de contrainte transféré depuis la couche donneuse de contrainte, lors de la fusion, est ainsi directement un état de contrainte uniaxiale. Il n'est pas nécessaire de mettre en œuvre d'autres étapes de modification de l'état de contrainte dans la couche semi-conductrice après ce transfert. En particulier, les étapes de découpe de la couche semi-conductrice coûteuses en matière consommée sont supprimées.

Le transfert d'un état de contrainte uniaxiale selon l'invention permet en outre d'augmenter l'épaisseur de couche semi-conductrice dépourvue de défauts cristallins. Dans le procédé connu, l'état de contrainte transféré est un état de contrainte biaxiale. Pour une intensité de contrainte donnée, l'épaisseur critique du matériau (à partir de laquelle on observe une relaxation plastique de la contrainte générant des défauts cristallins) est plus élevée lorsque la contrainte est uniaxiale que lorsqu'elle est biaxiale. Transférer directement un état de contrainte uniaxiale dans la couche semi-conductrice permet ainsi de réaliser une couche semi-conductrice sans défauts cristallins plus épaisse que celle réalisable par le procédé connu.

Par ailleurs, la modification de l'état de contrainte en amont du transfert offre plus de possibilités en termes d'ingénierie de l'état de contrainte. La modification peut être typiquement configurée pour produire un état de contrainte uniaxiale en compression ou un état de contrainte uniaxiale en tension, ce qui n'est plus possible après transfert par simple découpe de la couche semi-conductrice comme dans l'art antérieur.

La modification du premier état de contrainte en un deuxième état de contrainte uniaxiale se fait par altération partielle de la couche donneuse de contrainte. Cette altération peut être avantageusement réalisée par des étapes usuelles de la microélectronique, telles qu'une implantation localisée ou une gravure de tranchées dans la couche donneuse de contrainte.

Par conséquent et de façon avantageuse, le procédé de réalisation d'un état de contrainte uniaxiale dans une couche semi-conductrice selon la présente invention permet notamment une économie de matière et une meilleure versatilité vis-à-vis du procédé connu précédemment décrit. En mettant en oeuvre le procédé selon la présente invention, la densité d'intégration peut être avantageusement augmentée.

Un autre aspect de l'invention concerne un procédé de fabrication d'un transistor comprenant la mise en oeuvre du procédé de réalisation d'un état de contrainte uniaxiale selon l'invention. Selon ce procédé de fabrication, le transistor comprend une région de canal réalisée dans la couche semi-conductrice présentant l'état de contrainte uniaxiale. Les autres objets, caractéristiques et avantages de la présente invention apparaîtront à l'examen de la description suivante et des dessins d'accompagnement. Il est entendu que d'autres avantages peuvent être incorporés.

### BREVE DESCRIPTION DES FIGURES

En particulier, les buts, objets, ainsi que les caractéristiques et avantages de l'invention ressortiront mieux de la description détaillée d'au moins un mode de réalisation de cette dernière qui est illustré par les dessins d'accompagnement suivants dans lesquels :
La figure 1 illustre en coupe un empilement selon un mode de réalisation de la présente invention.
La figure 2 illustre en vue de dessus l'empilement illustré à la figure 1, selon un mode de réalisation de la présente invention.
La figure 3 illustre en coupe une étape de procédé (formation de tranchées d'isolation et de régions) selon un mode de réalisation de la présente invention.
La figure 4 illustre en vue de dessus l'étape de procédé (formation de tranchées d'isolation et de régions) illustrée à la figure 3, selon un mode de réalisation de la présente invention.
La figure 5 illustre en coupe une étape de procédé (formation de bandes implantées dans la couche donneuse de contrainte) selon un mode de réalisation de la présente invention.
La figure 6 illustre en vue de dessus l'étape de procédé (formation de bandes implantées dans la couche donneuse de contrainte) illustrée à la figure 5, selon un mode de réalisation de la présente invention.
La figure 7 illustre en coupe une étape de procédé (fusion partielle de la couche fusible) selon un mode de réalisation de la présente invention.
La figure 8 illustre en vue de dessus l'étape de procédé (fusion partielle de la couche fusible) illustrée à la figure 7, selon un mode de réalisation de la présente invention.
La figure 9 illustre en coupe une étape de procédé (retrait de la couche donneuse de contrainte) selon un mode de réalisation de la présente invention.
La figure 10 illustre en vue de dessus l'étape de procédé (retrait de la couche donneuse de contrainte) illustrée à la figure 9, selon un mode de réalisation de la présente invention.
La figure 11 illustre en coupe une étape de procédé (formation de tranchées de relaxation dans la couche donneuse de contrainte) selon un autre mode de réalisation de la présente invention.
La figure 12 illustre en vue de dessus l'étape de procédé (formation de tranchées de relaxation dans la couche donneuse de contrainte) illustrée à la figure 11, selon un autre mode de réalisation de la présente invention.
La figure 13 illustre en coupe une étape de procédé (remplissage des tranchées d'isolation) selon un autre mode de réalisation de la présente invention.
La figure 14 illustre en vue de dessus l'étape de procédé (remplissage des tranchées d'isolation) illustrée à la figure 13, selon un autre mode de réalisation de la présente invention.
La figure 15 illustre en coupe une étape de procédé (retrait de la couche donneuse de contrainte) selon un autre mode de réalisation de la présente invention.
La figure 16 illustre en vue de dessus l'étape de procédé (retrait de la couche donneuse de contrainte) illustrée à la figure 15, selon un autre mode de réalisation de la présente invention.
La figure 17 illustre la dépendance de la déformation obtenue dans un film de 10 nm de silicium sur 20 nm d'oxyde enterré en fonction du module d'Young et de la contrainte d'une couche donneuse de contrainte de 100 nm d'épaisseur, selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs des différentes couches et les dimensions des différents motifs qui sont illustrés par des schémas qui ne sont pas représentatifs de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, le procédé comprend en outre un remplissage des tranchées pour former des tranchées d'isolation, après fusion de la couche fusible et avant un retrait de la couche donneuse de contrainte. Cela permet de confiner certaines régions de la couche semi-conductrice entre les tranchées d'isolation pour éviter une relaxation, typiquement selon la direction y de contrainte uniaxiale, des régions de couche semi-conductrice après retrait de la couche donneuse de contrainte. Cela permet par exemple d'augmenter l'état de contrainte uniaxiale. Cela permet par exemple de limiter des pertes de contraintes lors du transfert de l'état de contrainte dans la couche semi-conductrice.

Selon un exemple, l'altération partielle comprend une implantation d'ions dans une partie de la couche donneuse de contrainte formant des bandes implantées orientées selon la direction déterminée, lesdites bandes implantées s'étendant sur toute une dimension de la couche donneuse de contrainte selon la direction déterminée. Cette implantation se fait typiquement selon toute l'épaisseur de la couche donneuse de contrainte. La largeur des bandes implantées est de préférence inférieure ou égale à la moitié de l'épaisseur de la couche donneuse de contrainte. Typiquement, si les bandes implantées visent à relaxer la couche donneuse de contrainte selon une direction x, la largeur selon x des bandes implantées est de préférence choisie aussi faible que possible (cette largeur minimale est typiquement fixée par la résolution de l'équipement de lithographie utilisé pour réaliser le masque définissant les bandes à implanter). Si les bandes implantées visent à induire un état de compression uniaxiale selon y dans la couche donneuse de contrainte, la largeur selon x des bandes implantées peut être choisie de l'ordre de la moitié de l'épaisseur de la couche donneuse de contrainte, voire de l'ordre du tiers de l'épaisseur de la couche donneuse de contrainte. La longueur selon y des bandes implantées est typiquement largement supérieure, c'est-à-dire au moins dix fois supérieure, à l'épaisseur de la couche donneuse de contrainte. Cela limite ou évite une relaxation de la couche donneuse de contrainte selon y.

Selon un exemple, les régions présentent une dimension selon la direction déterminée significativement supérieure à l'épaisseur de la couche donneuse de contrainte, typiquement au moins six fois supérieure à l'épaisseur de la couche donneuse de contrainte. Cela permet d'optimiser le transfert de contrainte uniaxiale selon la direction déterminée dans la couche semi-conductrice.

Selon un exemple, les ions implantés sont à base d'argon. L'état de contrainte de la couche donneuse de contrainte est ainsi modifié sans exposer la couche semi-conductrice sous-jacente. La couche semi-conductrice reste donc protégée vis-à-vis d'autres étapes de procédé, typiquement lors de la formation, du remplissage et de la planarisation des tranchées d'isolation.

Selon un exemple, le premier état de contrainte est sensiblement nul et le deuxième état de contrainte correspond à une compression uniaxiale. La couche donneuse de contrainte peut être initialement relaxée, avant altération. Une implantation d'argon dans des bandes orientées selon la direction déterminée permet typiquement de générer une telle compression uniaxiale dans une couche donneuse de contrainte à base de SiN, par exemple.

Selon un exemple, le premier état de contrainte correspond à une tension biaxiale et le deuxième état de contrainte correspond à une tension uniaxiale. La couche donneuse de contrainte, par exemple à base de SiN, peut être initialement en tension biaxiale, avant altération. Une implantation d'argon dans des bandes orientées selon la direction déterminée permet typiquement de relaxer la contrainte dans ces bandes. La couche donneuse de contrainte présente alors des bandes relaxées et un état de contrainte résiduel en tension uniaxiale entre les bandes relaxées.

Selon un exemple, l'altération partielle comprend une formation de tranchées de relaxation dans la couche donneuse de contrainte, orientées selon la direction déterminée. Il est ainsi possible de passer d'un état de contrainte biaxiale à un état de contrainte uniaxiale en formant des tranchées de relaxation dans la couche donneuse de contrainte, de préférence selon toute l'épaisseur de la couche donneuse de contrainte.

Selon un exemple, les tranchées de relaxation sont séparées par des bandes de couche donneuse de contrainte présentant une largeur environ égale à une moitié de l'épaisseur de la couche donneuse de contrainte.

Selon un exemple, l'altération partielle comprend une formation de tranchées de relaxation dans la couche donneuse de contrainte de certaines régions, et une implantation d'ions dans des bandes de la couche donneuse de contrainte pour d'autres régions. Les deux types d'altération partielle peuvent ainsi coexister pour différentes régions d'une même plaque ou wafer.

Selon un exemple, l'empilement comprend une couche isolante entre la couche semi-conductrice et la couche fusible. Selon un exemple, la couche isolante est à base de silice. Elle présente de préférence une épaisseur comprise entre 10 nm et 25 nm. Cette architecture correspond typiquement à la technologie FDSOI. La faible raideur de la silice, qui présente un module d'Young E de l'ordre de 50 GPa, et l'épaisseur limitée favorisent la transmission d'un état de contrainte entre la couche donneuse de contrainte et la couche semi-conductrice.

Selon un exemple, la couche donneuse de contrainte est à base de nitrure de silicium. Ce matériau a l'avantage d'être transparent dans l'UV, dans une gamme de longueurs d'onde convenant à la fusion de la couche fusible. Il peut également être avantageusement utilisé pour le remplissage des tranchées d'isolation, typiquement des tranchées d'isolation peu profondes STI (acronyme de « Shallow Trench Isolation ») mises en œuvre pour l'isolation latérale en technologie FDSOI. Les étapes de remplissage des tranchées d'isolation et de dépôt de la couche donneuse de contrainte peuvent ainsi être réalisées simultanément, au moins en partie. Cela diminue le nombre d'étapes et le coût du procédé.

Selon une possibilité préférée, la fusion est effectuée par recuit thermique de type recuit thermique rapide, typiquement sur toute l'étendue de la couche fusible, c'est-à-dire sur toute la plaque. L'utilisation d'un recuit thermique rapide permet un échauffement collectif des régions formées dans la couche semi-conductrice, indépendamment des dimensions desdites régions. Selon un autre exemple, ce recuit thermique est effectué à l'aide d'un laser nanoseconde, typiquement en balayant la plaque avec le faisceau laser. L'utilisation d'un laser permet une élévation thermique rapide et localisée de l'empilement de couches à une température prédéterminée autorisant la fusion de la couche fusible tout en évitant une diffusion intempestive d'atomes dans l'empilement. Le budget thermique reste ainsi limité. Selon un exemple, le laser est un laser pulsé présentant des impulsions dont la durée est inférieure à une microseconde et de préférence comprise entre 10 ns et 1000 ns, avantageusement entre 20 ns et 500 ns. Le laser présente une longueur d'onde typiquement comprise entre 100 nm et 550 nm, et de préférence comprise entre 250 nm et 400 nm.

Selon un exemple, la couche fusible est amorphe. Cela permet d'abaisser le point de fusion de la couche fusible, en comparaison à une couche fusible à base du même matériau sous forme cristalline. Par exemple, une couche fusible à base de SiGe sous forme cristalline contenant 65% de Ge fond autour de 1100°C, tandis qu'une couche fusible à base de SiGe sous forme amorphe contenant 65% de Ge fond en-dessous de 1000°C.

Selon un exemple, la couche fusible amorphe est formée par épitaxie avant d'être amorphisée par implantation. Cela permet d'obtenir une couche fusible amorphe peu rugueuse et contenant peu d'hydrogène.

Selon un exemple, la couche semi-conductrice est à base de silicium ou de silicium-germanium et la couche fusible est à base de silicium-germanium ou de germanium et présente une teneur en germanium plus élevée que la couche semi-conductrice. Plus la teneur en germanium est élevée, plus le point de fusion diminue. Avantageusement, la couche fusible fond tandis que la couche semi-conductrice reste à l'état solide. Les compositions relatives des couches fusible et semi-conductrice sont typiquement choisies à cet effet. Selon un exemple, la couche semi-conductrice est à base de silicium-germanium ou de germanium et la couche fusible est à base de silicium-germanium et d'étain ou de germanium et d'étain. L'étain abaisse encore le point de fusion des alliages à base de germanium.

Sauf incompatibilité, des caractéristiques techniques décrites en détail pour un mode de réalisation donné peuvent être combinées aux caractéristiques techniques décrites dans le contexte d'autres modes de réalisation décrits à titre exemplaire et non limitatif. En particulier, des éléments décrits ou illustrés pour certains modes de réalisation du procédé peuvent être combinés de manière à former un autre mode de réalisation qui n'est pas nécessairement illustré ou décrit. Un tel mode de réalisation n'est évidemment pas exclu de l'invention.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants. Ainsi, une couche à base de silicium s'entend par exemple d'une couche Si, Si dopé n, Si dopé p.

La présente invention permet notamment la réalisation d'un état de contrainte uniaxiale dans une couche semi-conductrice. Cette couche semi-conductrice correspond typiquement à la couche supérieure, appelée « topSi », d'un substrat silicium sur isolant SOI (acronyme de l'anglais « silicon on insulator »). L'invention peut être mise en œuvre pour la réalisation de différents dispositifs ou composants microélectroniques selon des architectures du type FDSOI, FinFET (transistor à effet de champ dont le canal est formé dans une forme d'ailette ou de nageoire, « fin » en anglais) ou encore « nanosheet » (empilement de couches minces formant les couches actives des transistors). L'invention peut également être mise en œuvre pour la réalisation de différents dispositifs ou composants optoélectroniques, par exemple des lasers, des guides d'onde biréfringents ou des amplificateurs. L'invention peut être mise en œuvre plus largement pour la réalisation de tout dispositif comprenant une couche mince semi-conductrice présentant un état de contrainte uniaxiale.

Plusieurs modes de réalisation de l'invention mettant en œuvre des étapes successives du procédé de réalisation sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, l'épaisseur d'une couche est prise selon une direction normale au plan d'extension principal de la couche. La hauteur d'un dispositif ou la profondeur d'un motif, par exemple une tranchée, sont prises selon la direction z. Ainsi, une couche présente typiquement une épaisseur selon z et une tranchée présente typiquement une profondeur selon z. Les termes relatifs « sur », « surmonte », « sous », « sous-jacent » se réfèrent à des positions prises selon la direction z.

Les termes « vertical », « verticalement » se réfèrent à une direction selon z. Les termes « horizontal », « horizontalement » se réfèrent à une direction dans le plan xy. Le terme « latéral » se réfère à un plan xz ou yz. Ainsi, les flancs latéraux des tranchées d'isolation s'étendent parallèlement à un plan yz et/ou xz. Sauf mention explicite, l'épaisseur, la hauteur et la profondeur sont mesurées selon z.

Un élément situé « à l'aplomb » ou « au droit d'» un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

Le procédé comprend une définition de motifs après formation de la couche donneuse de contrainte, et une formation de régions dans la couche semi-conductrice à partir desdits motifs. Ces motifs et régions ne sont pas assimilables à une altération partielle de la couche donneuse de contrainte. Ces motifs et régions visent à structurer l'empilement, notamment en vue d'une intégration au sein de dispositifs fonctionnels tels que des transistors. Les dimensions de ces motifs, en particulier selon y et/ou selon x, sont très supérieures aux dimensions des bandes implantées ou des tranchées de relaxation, en particulier très supérieures à leur épaisseur ou leur hauteur.

Un état de contrainte mécanique est généralement décrit par un tenseur. Dans le cadre de la présente invention, seules les composantes diagonales du tenseur, et en particulier les composantes dans le plan xy, sont considérées.

Par déformation mécanique d'une couche semi-conductrice on entend que son matériau a son ou ses paramètre(s) de maille cristalline allongé(s) ou écourté(s).

Dans le cas où le paramètre de maille déformé est plus important que le paramètre dit « naturel » d'un matériau cristallin, celui-ci est dit en déformation en tension. Lorsque le paramètre de maille déformé est plus petit que le paramètre de maille naturel, le matériau est dit en déformation compressive ou en compression.

A ces états de déformation mécanique, on associe des états de contraintes mécaniques. Pour autant, il est également commun de se référer à ces états de déformation comme des états de contraintes mécaniques. Dans la suite de la présente demande, cette notion de déformation (« strain » selon la terminologie anglo-saxonne) sera désignée de façon générique par le terme « contrainte », ou « stress » en anglais.

La couche donneuse de contrainte est également appelée « stressor » selon la terminologie anglo-saxonne.

On entend par fusion le passage, de manière transitoire, d'au moins une épaisseur donnée de la couche fusible d'un état solide à un état liquide. Avantageusement, le matériau de la couche fusible présente une température de fusion ou de liquidus inférieure à la température de fusion ou de liquidus du matériau semi-conducteur de la couche semi-conductrice.

Dans ce qui suit, le terme « absorption » ou ses équivalents se réfère au phénomène par lequel l'énergie d'une onde électromagnétique est transformée en une autre forme d'énergie, par exemple sous forme de chaleur. Dans la présente description, un matériau est considéré comme absorbant dès lors qu'il absorbe au moins 50% d'un rayonnement lumineux, de préférence au moins 75% et avantageusement au moins 90%. Il peut être caractérisé par un facteur d'absorption compris entre 0 et 1.

Par ailleurs, une couche est dite transparente lorsqu'elle présente un coefficient de transmission supérieur ou égal à 50%, de préférence à 75%, voire à 90% pour une longueur d'onde centrale de la gamme spectrale du rayonnement électromagnétique incident.

Pour déterminer la composition et l'état de contrainte des différentes couches, on peut procéder à des analyses de microscopie électronique, en particulier de Microscopie Electronique à Balayage (MEB) ou de Microscopie Electronique en Transmission (MET ou TEM).

Les compositions chimiques des différentes couches ou régions peuvent être déterminées à l'aide de la méthode bien connue EDX ou X-EDS, acronyme de « energy dispersive x-ray spectroscopy » qui signifie « analyse dispersive en énergie de photons X ».

Cette méthode est bien adaptée pour analyser la composition de couches de faibles épaisseurs telles que la couche semi-conductrice et la couche donneuse de contrainte. Elle peut être mise en œuvre sur des coupes métallurgiques au sein d'un MEB ou d'un MET.

La diffraction d'électrons par précession (PED) peut être mise en œuvre au sein d'un TEM pour déterminer l'état de contrainte de couches de faibles épaisseurs telles que la couche semi-conductrice. D'autres techniques de microscopie électronique ou de diffraction sont également envisageables. Des techniques de spectroscopie optique, par exemple la spectroscopie Raman, peuvent également être mises en œuvre.

Ces techniques permettent notamment de déterminer l'état de contrainte de la couche semi-conductrice, et la disposition et la composition des différentes couches au sein de l'empilement.

Une couche semi-conductrice en tension uniaxiale au-dessus d'une couche « solidifiée » à base de silicium-germanium (correspondant à une couche fusible), peuvent être des indices de mise en œuvre du procédé selon la présente invention.

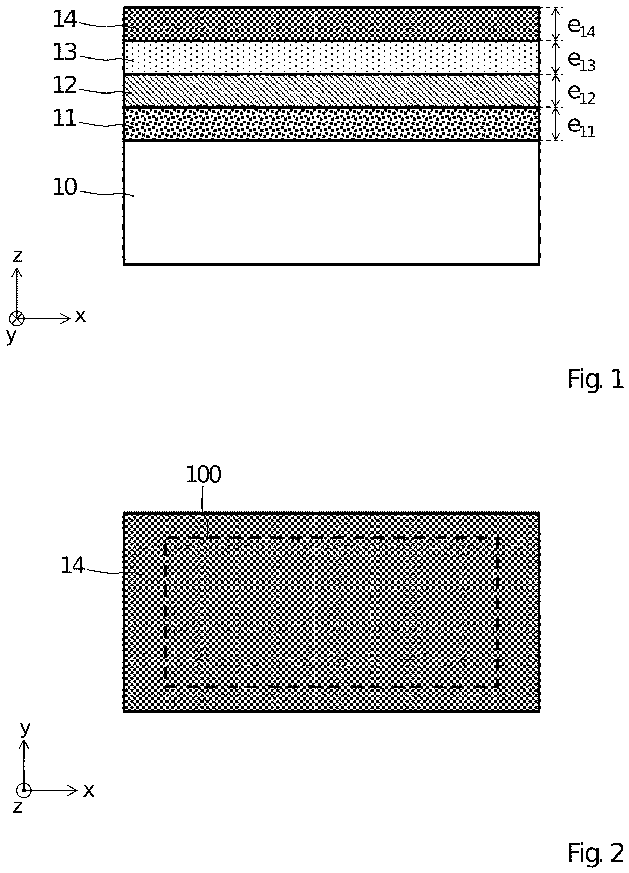

La figure 1 illustre un empilement comprenant un support 10, une couche fusible 11, une couche isolante 12, une couche semi-conductrice 13 et une couche donneuse de contrainte ou stressor 14.

Le support 10 correspond typiquement à un substrat massif, dit « bulk », en silicium monocristallin. Le support 10 présente typiquement une résistivité de l'ordre de 20 Ω.cm. Pour certaines applications, par exemple pour des applications RF, le support 10 peut présenter une résistivité supérieure ou égale à 100 Ω.cm. L'empilement peut comprendre d'autres couches, typiquement entre le substrat 10 et la couche fusible 11. Une couche de silicium poreux ou une couche comprenant une zone capable de piéger une grande quantité de charges mobiles (généralement désignée « trap rich ») peut par exemple être intercalée entre le substrat 10 et la couche fusible 11.

La couche fusible 11 est de préférence à base d'un alliage SiGe monocristallin ou polycristallin dont la teneur en Ge est choisie de façon à ce que le liquidus de l'alliage soit notablement plus faible que celui du reste de l'empilement, et notamment plus faible que le liquidus ou le point de fusion de la couche semi-conductrice 13. Une différence de température de fusion/liquidus entre la couche semi-conductrice 13 et la couche fusible 11 supérieure ou égale à 50°C, et de préférence supérieure ou égale à 80°C, est typiquement requise. Ainsi, le choix de la composition de la couche fusible 11 se fait relativement à la composition de la couche semi-conductrice 13.

Par exemple, lorsque la couche semi-conductrice 13 est en silicium, la couche fusible 11 peut présenter une teneur en germanium comprise entre 30%at et 99%at, avantageusement entre 40%at et 70%at.

Si la couche semi-conductrice 13 contient du germanium, la couche fusible 11 peut contenir de l'étain. Cela contribue à maintenir une différence de température de fusion/liquidus acceptable entre la couche semi-conductrice 13 et la couche fusible 11.

La couche fusible 11 peut être formée par épitaxie ou par dépôt chimique en phase vapeur CVD (« Chemical Vapor Deposition ») sur le support 10. La couche fusible 11 présente typiquement une épaisseur e₁₁ comprise entre 5 nm et 20 nm.

Lorsque la couche semi-conductrice 13 est formée directement au contact de la couche fusible 11, par épitaxie, la couche fusible 11 est de préférence monocristalline. L'épaisseur de la couche fusible 11 est de préférence inférieure à son épaisseur critique de relaxation plastique (voir par exemple, dans le cas d'une couche fusible 11 à base de SiGe sur un support 10 à base de Si, le document « Critical thickness for plastic relaxation of SiGe on Si(001) revisited » de J.M Hartmann et al. publié dans Journal of Applied Physics 110, 083529 (2011)). On évite ainsi la formation de dislocations dans la couche semi-conductrice 13 lors de la croissance de la couche semi-conductrice 13 sur la couche fusible 11.

Selon une possibilité, la couche fusible 11 est amorphe. Cela permet d'abaisser le point de fusion de la couche fusible 11, en comparaison d'une couche fusible 11 cristalline de même composition chimique. A titre d'exemple, une couche fusible à base de SiGe sous forme cristalline présentant une concentration en Ge de 65%at fond autour de 1100°C, tandis qu'une couche fusible à base de SiGe sous forme amorphe présentant la même concentration en Ge de 65%at fond en-dessous de 1000°C.

La couche fusible 11 amorphe peut être formée en deux étapes. Une première étape consiste à épitaxier la couche fusible 11 sous forme cristalline sur le support 10. Une deuxième étape consiste à amorphiser la couche fusible 11 par implantation ionique. Cela permet d'obtenir une couche fusible amorphe peu rugueuse et contenant peu d'hydrogène.

Les conditions d'implantation pour l'amorphisation d'au moins une partie de l'épaisseur de la couche fusible 11 peuvent être définies à l'aide d'un outil de simulation, par exemple à l'aide d'un logiciel de type C-TRIM (CTRIM pour « Crystal Transport of Ions in Matter ») utilisant des algorithmes basés sur la méthode de Monté Carlo. Pour le cas spécifique d'une couche semi-conductrice 13 en Si et d'une couche fusible 11 en SiGe, des ions de Si peuvent être utilisés par exemple. La dose implantée est calculée de manière à engendrer l'amorphisation de la couche fusible de SiGe. Une gamme typique de dose pour le SiGe peut se situer entre 1,5e14 et 3e14 at/cm². La profondeur d'amorphisation s'étend de préférence selon toute l'épaisseur e₁₁ de la couche fusible 11.

La couche isolante 12 est optionnelle. Elle peut être du type « oxyde enterré » ou « BOX » (signifiant « Burried Oxyde » en anglais) dans une architecture SOI (« Silicon On Insulator »). Elle est de préférence à base de silice, et présente une épaisseur e₁₂ typiquement comprise entre 10 nm et 25 nm. La faible raideur de la silice, qui présente un module d'Young E de l'ordre de 50 GPa, et l'épaisseur limitée favorisent la transmission d'un état de contrainte entre la couche 14 donneuse de contrainte et la couche semi-conductrice 13. Cette configuration est favorable dans le cas d'une architecture FDSOI. Pour certaines applications, par exemple dans le cas d'une structure à forte capacitance verticale, la couche isolante 12 peut être alternativement à base d'un matériau à forte permittivité. Dans ce cas, la couche isolante 12 peut être à base d'alumine Al₂O₃ ou d'un oxy-nitrure de silicium-hafnium HfSiON avec des épaisseurs e₁₂ comprises entre 5 nm et 25 nm.

La couche semi-conductrice 13 est typiquement destinée à former une ou des zones actives d'un dispositif microélectronique. La couche semi-conductrice 13 est à base d'un matériau semi-conducteur dopé ou intrinsèque. Elle peut présenter un dopage de type P ou de type N, en fonction des applications.

Selon un exemple, la couche semi-conductrice 13 est en silicium monocristallin et présente une épaisseur e₁₃ comprise entre 5 nm et 20 nm. Pour réaliser le substrat SOI correspondant, une séquence de fabrication basse température peut être avantageusement utilisée, par exemple telle que divulguée dans le document FR3116940 A1 ou dans le document FR3125631 A1, intégrés ici par référence. Une telle séquence de fabrication basse température permet de rester en-dessous de la température de liquidus de la couche fusible 11 lors de la formation de la couche semi-conductrice 13. Une telle séquence de fabrication basse température peut être en particulier mise en œuvre lorsque la couche fusible 11 contient plus de 60% de Ge, ou lorsqu'il est souhaitable que celle-ci reste amorphe avant fusion et transfert de l'état de contrainte dans la couche semi-conductrice 13.

Selon un autre exemple, la couche semi-conductrice 13 est à base d'un alliage de SiGe avec une fraction atomique de Ge comprise entre 10% et 60 %. Dans ce cas, la couche semi-conductrice 13 présente de préférence une épaisseur inférieure à l'épaisseur critique, typiquement comprise entre 5 nm et 20 nm. Lorsqu'une telle couche semi-conductrice 13 est utilisée, la couche fusible 11 présente typiquement une teneur en Ge plus élevée et contient éventuellement du Sn.

Selon un autre exemple, la couche semi-conductrice 13 comprend une pluralité de couches monocristallines de silicium et de silicium-germanium alternées. Les couches de silicium-germanium peuvent typiquement comprendre entre 20 et 60% de Ge. Chacune des couches monocristallines présente typiquement une épaisseur comprise entre 5 nm et 10 nm. Une telle couche semi-conductrice 13 permet notamment la formation de transistors de type « nanosheet ».

La couche donneuse de contrainte ou stressor 14 est de préférence à base de nitrure de silicium SiN. Ce matériau a l'avantage d'être transparent dans l'UV, dans une gamme de longueurs d'onde convenant à la fusion de la couche fusible 11. Ce matériau est également largement utilisé pour d'autres étapes de procédé dans le domaine de la microélectronique. Il est bien connu et parfaitement compatible avec de nombreuses applications. Par ailleurs, la température de fusion du nitrure de silicium est de l'ordre de 1900°C, soit strictement supérieure à celle du silicium et de la plupart des semiconducteurs utilisés en tant que couche semi-conductrice 13 et/ou couche fusible 11. Le stressor 14 reste ainsi à l'état solide lors de l'étape de transfert de contrainte impliquant la fusion de la couche fusible 11. Le stressor 14 présente typiquement une épaisseur e₁₄ comprise entre 30 nm et 200 nm.

Le stressor 14 peut être déposé par CVD sur la couche semi-conductrice 13. Ce dépôt peut être assisté par plasma. Selon une possibilité, un oxyde fin, de l'ordre de 1 nm à 5 nm, est formé sur la couche semi-conductrice 13 avant le dépôt du stressor 14 à base de nitrure de silicium (non illustré). Cela permet de faciliter le retrait ultérieur du stressor 14. Selon une possibilité, le stressor 14 à base de SiN est déposé sans contrainte interne. Alternativement, différents états de contrainte peuvent être obtenus lors du dépôt du SiN. Selon une possibilité, un stressor 14 à base de SiN en contrainte tensile, typiquement jusqu'à 1,5 GPa, peut être formé par dépôt CVD. Selon une autre possibilité, un stressor 14 à base de SiN en contrainte compressive, typiquement jusqu'à -2 GPa voire -3 GPa, peut être formé par dépôt CVD. D'autres précisions sur le type de contrainte en fonction du type de dépôt ou des conditions de dépôt peuvent être trouvées dans le document « A comparison of the mechanical stability of silicon nitride films deposited with various techniques » de Pierre Morin et al. publié dans Applied Surface Science 260 (2012) 69-72, dans le cas d'un stressor 14 à base de de nitrure de silicium.

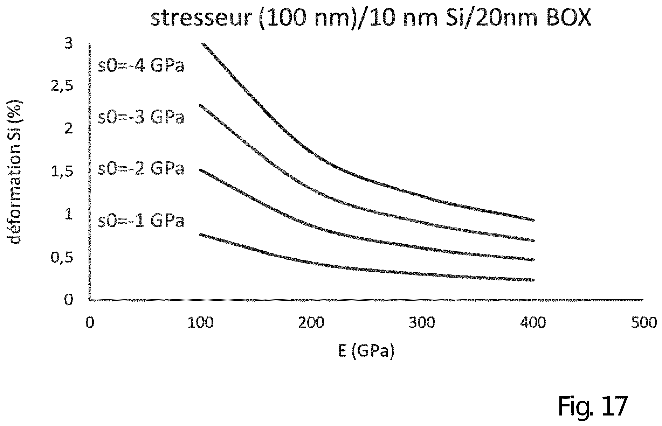

D'autres matériaux peuvent être utilisés pour le stressor 14, par exemple Al₂O₃ ou Ga₂O₃. Les paramètres à prendre en compte pour le choix du matériau de stressor 14 sont principalement la transparence dans l'UV (lorsque la fusion est faite par laser), la capacité à être déposé avec une contrainte interne élevée et un module d'Young relativement faible. La figure 17 illustre la dépendance de la déformation obtenue dans une couche de Si de 10 nm d'épaisseur sur une couche d'oxyde enterré de 20 nm d'épaisseur, en fonction du module d'Young E et de la contrainte initiale s0 d'un stressor de 100 nm d'épaisseur. Un stressor à base de nitrure de silicium déposé par CVD assisté par plasma (PECVD) présentant typiquement une contrainte compressive initiale de -2 GPa permet d'obtenir une déformation de la couche de Si entre 1 et 1,5%.

Comme illustré à la figure 2, une région de la couche semi-conductrice à déformer peut être préalablement définie par l'intermédiaire d'un motif 100. Il peut s'agir d'une séquence commune au procédé de fabrication FDSOI visant à former des zones actives de transistors. Le motif 100 comprend typiquement un masquage protégeant l'empilement dans la région à préserver.

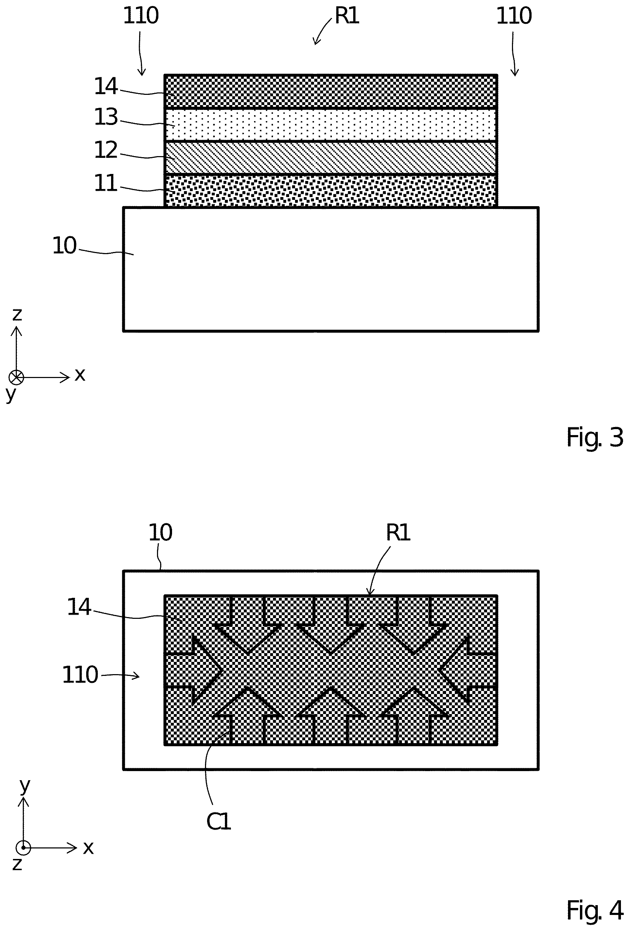

Comme illustré aux figures 3, 4, une structuration de l'empilement peut être effectuée par gravure des zones exposées, autour du motif 100. Cette gravure peut être effectuée par gravure sèche RIE (acronyme de « Reactive Ion Etching » signifiant gravure ionique réactive). La gravure se fait typiquement selon toute l'épaisseur de l'empilement, au moins jusqu'à la base de la couche fusible 11, typiquement sur une profondeur d'environ 200 nm à partir de la face supérieure de la couche semi-conductrice 13. Des tranchées 110 entourant une région R1 de couche semi-conductrice 13 sont ainsi formées. Une ou plusieurs étapes de définition de motifs et de gravure peuvent être enchaînées, par exemple dans le cadre d'une structuration dite par « double patterning », en fonction des dimensions visées pour la région R1 et de l'équipement de lithographie utilisé. Différentes profondeurs de tranchées 110 peuvent également être réalisées, par exemple dans le cadre d'une technologie dite de « double STI ».

Il est avantageux de définir des régions R1 de la plus grande dimension possible dans la direction y pour optimiser le transfert de contrainte uniaxiale selon y dans la couche semi-conductrice 13. Une possibilité consiste à prévoir des zones actives consécutives du même type de conductivité (N ou P) aboutées selon la direction y (direction de circulation du courant) en remplaçant les tranchées 110 de séparation par des grilles inactives. Une telle organisation est dite « en zone active continue » ou « continuous RX ». Selon une possibilité, la dimension selon y de la région R1 est supérieure ou égale à sixfois l'épaisseur de stressor. Cela permet d'atteindre la valeur de contrainte maximale théoriquement transférable par le stressor, en s'éloignant du bord libre de la région R1. La topologie de zone active continue permet *in fine* d'obtenir des canaux de transistors plus fortement contraints, produits à partir d'un stressor de contrainte et d'épaisseur donnée. Après structuration, le stressor 14 surmontant la couche semi-conductrice 13 dans la région R1 présente un état de contrainte biaxiale C1 dans le plan xy. Sur la figure 4, l'état de contrainte biaxiale C1 illustré pour le stressor 14 est en compression. Comme évoqué plus haut, cet état de contrainte C1 peut être alternativement en tension ou nul.

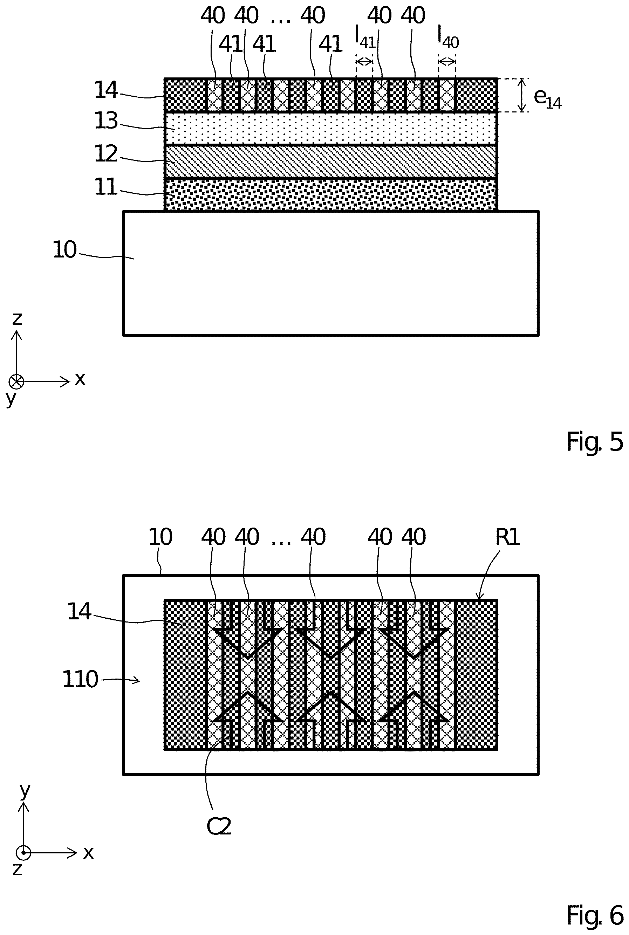

Comme illustré aux figures 5, 6, selon un mode de réalisation, le stressor 14 est altéré par la formation de bandes 40 dirigées selon y. Cette altération modifie l'état de contrainte biaxiale C1 pour produire un état de contrainte uniaxiale C2.

Une première façon d'altérer le stressor 14 consiste à implanter les bandes 40 du stressor 14 avec des ions argon. L'énergie d'implantation est de préférence choisie de façon à ce que les ions argon restent confinés dans l'épaisseur e₁₄ du stressor 14 tout en étant distribués de façon homogène le long de l'épaisseur e₁₄ du stressor 14. Cette implantation change typiquement la contrainte des bandes 40 de stressor 14 en décalant la contrainte initiale dans le sens de la compression. La dose implantée, l'énergie d'implantation et l'épaisseur e₁₄ du stressor 14 déterminent l'intensité du décalage en contrainte obtenu. Par exemple, l'implantation de 3x10e15 at/cm² d'argon à 30 keV dans une couche de 100 nm de nitrure de silicium provoque un décalage en contrainte d'environ -4 GPa, dans le sens de la compression. En réduisant la dose d'argon à 1x10e14 at/cm² à une énergie de 30 keV, le décalage avoisine -1,5 GPa, ce qui suffit à relaxer un stressor 14 initialement tensile à 1,5 GPa.

L'implantation est de préférence effectuée après un masquage lithographique configuré pour définir et exposer des bandes 40 de stressor 14, et masquer des bandes 41 de stressor 14.

Selon une possibilité, l'état de contrainte biaxiale C1 initial du stressor 14 est en tension à 1,5 GPa. L'implantation forme alors des bandes 40 de nitrure sensiblement relaxées. L'état de contrainte C2 du stressor 14 obtenu à l'issue de l'implantation est globalement en tension uniaxiale à 1,5 GPa. Ceci est dû aux bandes 41 de stressor 14 non implantées qui n'ont pas relaxé selon la direction y. La lithographie est de préférence configurée de sorte que les bandes 41 présentent une largeur l₄₁ selon x environ égale à la moitié de l'épaisseur e₁₄ du stressor 14. Les bandes 40 présentent de préférence une largeur l₄₀ selon x aussi petite que permis par la lithographie.

Selon une autre possibilité, l'état de contrainte biaxiale C1 initial du stressor 14 est relaxé. L'implantation forme alors des bandes 40 de nitrure en compression, par exemple à -1,5 GPa pour une dose implantée de 1x10e14 at/cm² à 30 keV. Dans ce cas, l'état de contrainte C2 du stressor 14 obtenu à l'issue de l'implantation est globalement en compression uniaxiale à -1,5 GPa. Dans ce cas, les bandes 40 présentent de préférence une largeur l₄₀ selon x environ égale à la moitié de l'épaisseur e₁₄ du stressor 14, et les bandes 41 présentent de préférence une largeur l₄₁ selon x aussi petite que permis par la lithographie.

Ce mode de réalisation d'altération par implantation a comme avantage de conserver la ou les régions R1 entièrement recouvertes par le stressor 14. L'état de contrainte du stressor est ainsi modifié sans exposer la couche semi-conductrice 13 sous-jacente. La couche semi-conductrice 13 reste donc protégée vis-à-vis d'autres étapes de procédé, typiquement lors de la formation, du remplissage et de la planarisation des tranchées d'isolation.

En dehors des régions R1 destinées à être mises sous contrainte uniaxiale, les mêmes étapes de masquage et implantation permettent avantageusement d'obtenir des régions totalement implantées ou totalement non implantées, i.e. totalement relaxées ou sous contrainte biaxiale. Par ailleurs, si la lithographie autorise la définition de bandes dans plusieurs directions du plan xy, des contraintes uniaxiales dans différentes directions du plan xy peuvent être obtenues. Le procédé permet donc avantageusement de réaliser différents états de contrainte uniaxiale sur certaines régions, tout en autorisant la réalisation conjointe d'états de contrainte biaxiale ou relaxé dans d'autres régions.

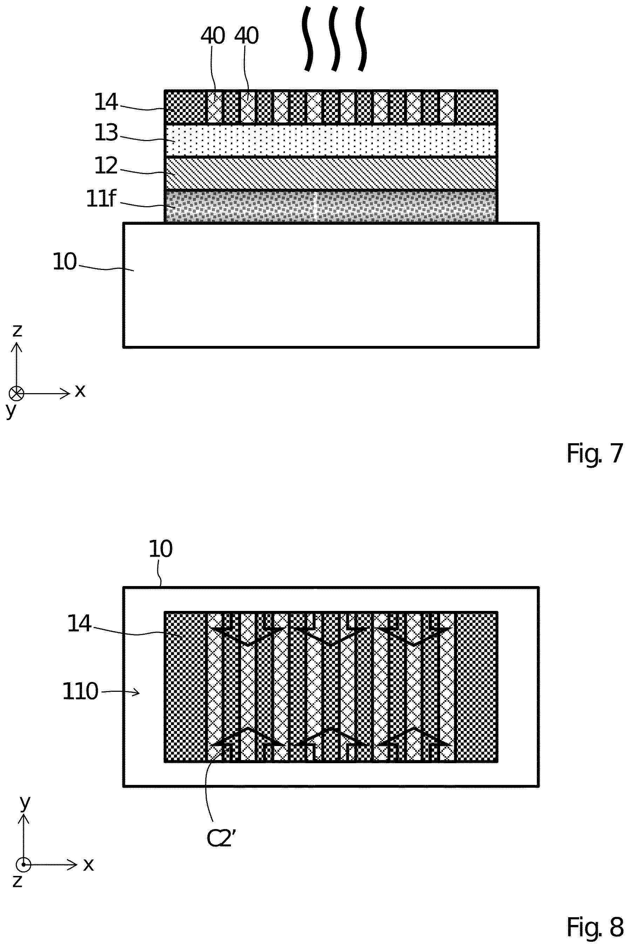

Comme illustré aux figures 7, 8, après altération du stressor 14, un traitement thermique est appliqué à l'empilement. Ce traitement thermique est configuré pour fondre au moins partiellement la couche fusible 11, qui devient une couche fondue 11f. Cela permet de libérer les contraintes imposées aux couches 12, 13, 14 supérieures par le support 10 et/ou la couche fusible 11. L'ensemble des couches 12, 13, 14 peut ainsi se relaxer dans une configuration de plus basse énergie élastique. En particulier, le stressor 14 va au moins en partie se relaxer en transférant tout ou partie de son état de contrainte C2 à la couche semi-conductrice 13 sous-jacente, et éventuellement à la couche isolante 12. Le stresseor 14 présente après relaxation un état de contrainte C2' résiduel inférieur à l'état de contrainte C2, voire sensiblement nul. Un bon transfert de l'état de contrainte C2 dans la couche semi-conductrice 13 est favorisé par des modules d'Young relativement faibles pour le stressor 14 et/ou la couche isolante 12 vis-à-vis de la couche semi-conductrice 13. L'état de contrainte C2' résiduel est alors minimisé.

En pratique, selon une possibilité préférée, le traitement thermique peut se faire par un recuit thermique rapide de type RTA (acronyme de « Rapid Thermal Annealing »). Ce type de recuit RTA permet avantageusement un transfert de chaleur relativement homogène sur toute l'étendue de la couche fusible, au niveau du wafer, sans influence significative de la taille des régions R1. Selon une autre possibilité, le traitement thermique est effectué à l'aide d'un laser, en particulier en soumettant l'empilement à une ou plusieurs impulsions laser. Les conditions de traitement thermique divulguées par le document FR3120738 A1 sont directement applicables au procédé selon l'invention. Au terme de l'étape de traitement laser, le retour dans un état solide de la couche fusible 11 permet de figer la contrainte dans la couche semi-conductrice 13. L'étape de traitement thermique conduisant à la fusion temporaire de la couche fusible 11 permet ainsi une modification de l'état de contrainte au sein de la couche semi-conductrice 13. L'utilisation d'un laser permet une élévation thermique rapide de l'empilement de couches à une température prédéterminée autorisant la fusion de la couche fusible 11 et la modification de contrainte dans la couche semi-conductrice 13, tout en limitant le budget thermique employé. Cela permet d'éviter une diffusion intempestive d'atomes dans l'empilement. L'utilisation du laser permet également un refroidissement rapide de l'empilement, une fois l'exposition au laser arrêtée. Un autre avantage de ce type de traitement thermique par faisceau laser est que la modification de l'état de contrainte peut se faire localement, de manière ciblée spatialement.

Selon un exemple, l'étape de traitement thermique est effectuée à l'aide d'un laser par émission d'une ou de plusieurs impulsions laser successives, la durée de chaque impulsion étant inférieure à une microseconde et de préférence comprise entre 10 ns et 1000 ns, avantageusement entre 20 ns et 500 ns. Le laser présente une longueur d'onde typiquement comprise entre 100 nm et 550 nm et de préférence comprise entre 250 nm et 400 nm. Les grandes longueurs d'onde peuvent être privilégiées pour éviter ou limiter l'influence de la taille des régions R1, dans le plan xy, sur l'énergie absorbée par l'empilement et en particulier par la couche fusible 11. Cela permet d'assurer des conditions de transfert de contrainte homogènes sur une plus grande gamme de tailles de région R1.

La longueur d'onde du laser, la durée d'impulsion du faisceau laser et de préférence la densité d'énergie du faisceau laser sont choisies en fonction de l'empilement de couches 11, 12, 13, 14, de sorte à permettre la fusion, au moins localement, du matériau de la couche fusible 11 tout en conservant au moins un film continu de la couche semi-conductrice 13 à l'état solide.

Selon un exemple de réalisation particulier, on peut prévoir une densité d'énergie comprise entre 0,01 et 2J/cm². L'Homme du Métier peut s'appuyer sur une combinaison d'outils de simulations par exemple tel qu'évoqué dans le document « LIAB: a FEniCS based computational tool for laser annealing simulation », de Lamagna et al., 2017, pour déterminer les conditions du recuit thermique rapide par laser.

Selon une possibilité, à l'issue d'un premier transfert de contrainte, le stressor 14 peut être remplacé ou de nouveau modifié, et un deuxième transfert de contrainte impliquant une deuxième fusion de la couche fusible 11 peut être effectué. Cela permet d'augmenter l'état de contrainte final de la couche semi-conductrice 13.

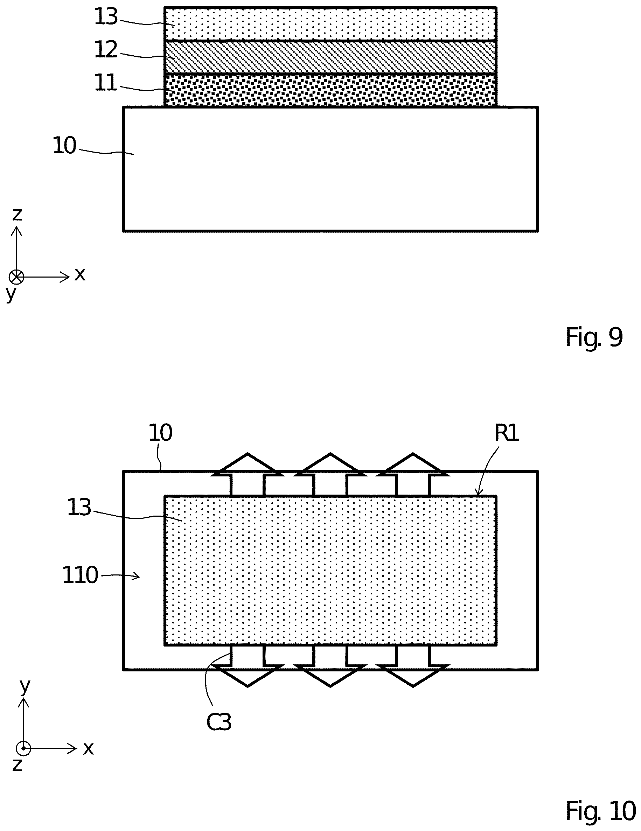

Comme illustré aux figures 9, 10, après transfert, le stressor 14 peut être retiré. La couche semi-conductrice 13 conserve alors un état de contrainte uniaxiale C3. Si le stressor 14 était en tension uniaxiale, la couche semi-conductrice 13 est typiquement en compression uniaxiale. Si le stressor 14 était en compression uniaxiale, la couche semi-conductrice 13 est typiquement en tension uniaxiale, comme illustré à la figure 10. Dans le cas d'une technologie basée sur une isolation par mesa, il n'y a pas de remplissage des tranchées 110 entre régions R1, ni étape de planarisation.

Selon une possibilité, après le transfert de contrainte, un recuit long à une température inférieure au liquidus de la couche fusible 11 SiGe est effectué. Cela permet de faire diffuser le germanium dans le support 10. La température de liquidus de la couche fusible 11 est augmentée. Cela permet d'éviter la fusion de la couche fusible 11 ultérieurement.

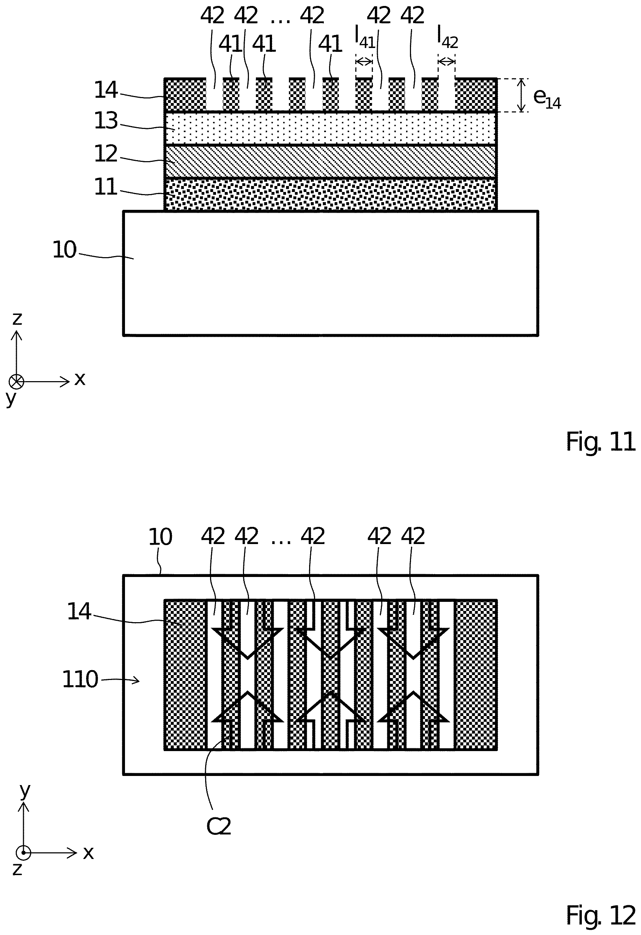

Les figures 11, 12 illustrent un autre mode de réalisation de l'étape d'altération du stressor 14. Selon ce mode de réalisation, l'altération du stressor 14 est obtenue en formant par gravure des tranchées de relaxation 42 dans l'épaisseur e₁₄ du stressor 14. Ces tranchées de relaxation 42 présentent de préférence une profondeur égale à l'épaisseur e₁₄ du stressor 14. Elles sont principalement dirigées selon y et régulièrement espacées entre elles selon x. Cela permet d'obtenir des bandes 41 de stressor 14 en contrainte uniaxiale selon y. Les bandes 41 présentent une largeur l₄₁ selon x environ égale à la moitié de l'épaisseur e₁₄ du stressor 14. Les tranchées de relaxation 42 présentent de préférence une largeur l₄₂ selon x aussi petite que permis par la lithographie et la gravure. Ces tranchées de relaxation 42 permettent de transformer l'état de contrainte biaxiale C1 du stressor 14 en état de contrainte uniaxiale C2. Ce mode de réalisation est notamment directement applicable à tous types et valeurs de l'état de contrainte biaxiale C1 non nulle.

Si la lithographie autorise la définition de tranchées 42 dans plusieurs directions du plan xy, des contraintes uniaxiales dans différentes directions du plan xy peuvent être obtenues. Par ailleurs, en dehors des régions R1 destinées à être mises sous contrainte uniaxiale, la superposition de tranchées 42 selon x et selon y permet avantageusement d'obtenir des régions totalement relaxées. Typiquement un tel quadrillage de tranchées 42 est configuré pour former des blocs de stressor 14 approximativement carrés, de longueur de côté de l'ordre de la moitié de l'épaisseur e₁₄ du stressor. Le procédé permet donc avantageusement de réaliser différents états de contrainte uniaxiale sur certaines régions, tout en autorisant la réalisation conjointe d'états de contrainte relaxé dans d'autres régions.

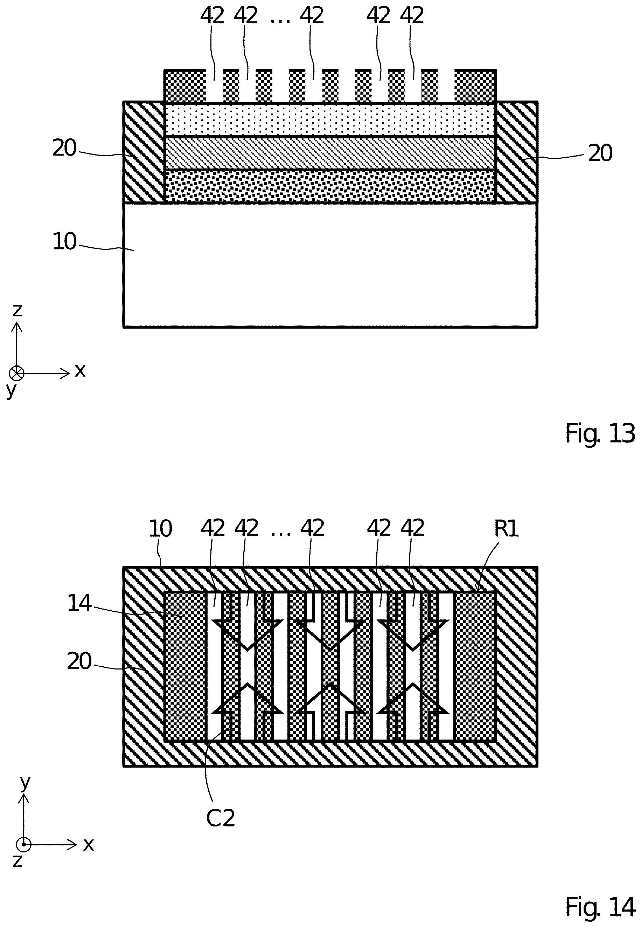

Les figures 13, 14 illustrent un autre mode de réalisation dans lequel les tranchées 110 sont remplies pour former des tranchées d'isolation 20, après transfert de l'état de contrainte par fusion temporaire de la couche fusible 11, et avant retrait du stressor 14. Les régions R1 sont ainsi confinées latéralement entre les tranchées d'isolation 20 avant retrait du stressor 14. Cela permet d'éviter une relaxation par les bords libres de l'empilement.

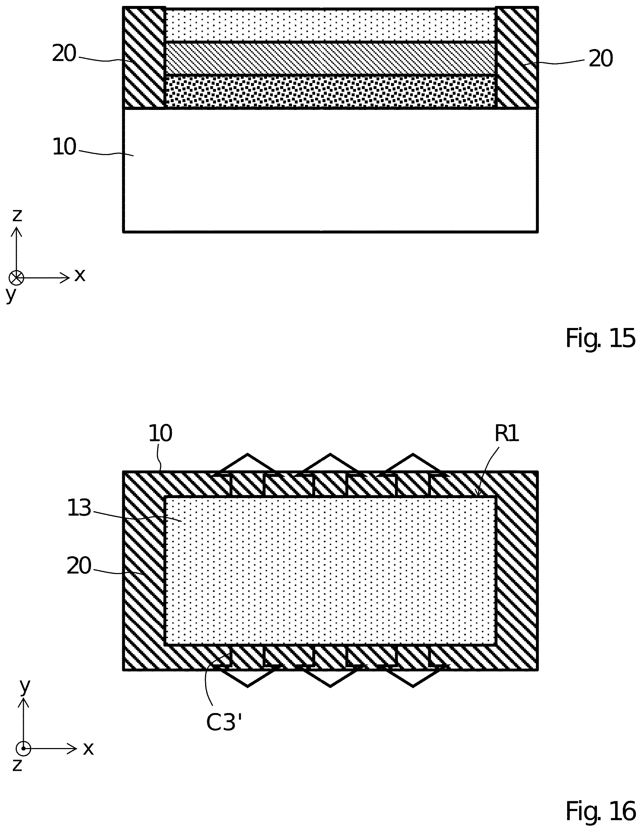

Comme illustré aux figures 15, 16, après retrait du stressor 14, l'état de contrainte uniaxiale C3' dans la couche semi-conductrice 13 est ainsi augmenté. Selon une possibilité, les tranchées d'isolation 20 s'étendent uniquement selon des plans yz, parallèlement à la direction de la contrainte uniaxiale. Cela favorise encore l'augmentation de contrainte uniaxiale dans la couche semi-conductrice 13.

Au travers des exemples précédemment décrits, il apparaît clairement que le procédé de réalisation d'un état de contrainte uniaxiale dans une couche semi-conductrice selon l'invention est particulièrement avantageux pour des applications du domaine de la microélectronique et/ou de l'optoélectronique. La réalisation de transistors sur une telle couche semi-conductrice contrainte uniaxialement bénéficie notamment d'une augmentation significative de la mobilité des porteurs de charge, en particulier pour des architectures de MOSFET FDSOI, FinFET et de MOSFET à canaux empilés (« nanosheet »).

L'invention n'est pas limitée aux modes de réalisations précédemment décrits. Différentes combinaisons d'altération du stressor et de structuration de l'empilement peuvent être envisagées. Ces étapes peuvent être interverties ou alternées.

## Revendications

1. Procédé de réalisation d'un état de contrainte uniaxiale (C3, C3') dans une couche semi-conductrice (13),
Ledit procédé comprenant au moins :
- Une fourniture d'un empilement comprenant un support (10), la couche semi-conductrice (13) et une couche (11) fusible intercalée entre le support (10) et la couche semi-conductrice (13),
- Une formation d'une couche (14) donneuse de contrainte sur la couche semi-conductrice (13),
- Une définition de motifs (100) après formation de la couche (14) donneuse de contrainte,
- Une formation, à partir desdits motifs (100), de régions (R1) entourées par des tranchées (110) s'étendant jusque dans la couche semi-conductrice (13),
- Une altération partielle de la couche (14) donneuse de contrainte au niveau desdites régions (R1), configurée pour modifier un premier état de contrainte (C1) de ladite couche (14) donneuse de contrainte de façon à obtenir un deuxième état de contrainte (C2) principalement selon une direction (y) déterminée,
- Une fusion au moins partielle de la couche fusible (11f), de façon à ce que la couche (14) donneuse de contrainte transfère au moins en partie, par relaxation, le deuxième état de contrainte (C2, C2') dans la couche semi-conductrice (13), de sorte à ce que la couche semi-conductrice (13) présente un état de contrainte uniaxiale (C3) selon ladite direction (y) déterminée.

2. Procédé selon la revendication précédente comprenant en outre un remplissage des tranchées (110) pour former des tranchées d'isolation (20), après fusion de la couche fusible (11) et avant un retrait de la couche (14) donneuse de contrainte.

3. Procédé selon l'une quelconque des revendications précédentes dans lequel l'altération partielle comprend une implantation d'ions dans une partie de la couche (14) donneuse de contrainte formant des bandes implantées (40) orientées selon la direction (y) déterminée, lesdites bandes implantées (40) s'étendant sur toute une dimension de la couche (14) donneuse de contrainte selon la direction (y) déterminée.

4. Procédé selon la revendication précédente dans lequel le premier état de contrainte (C1) est sensiblement nul et le deuxième état de contrainte (C2) correspond à une compression uniaxiale.

5. Procédé selon la revendication 3 dans lequel le premier état de contrainte (C1) correspond à une tension biaxiale et le deuxième état de contrainte (C2) correspond à une tension uniaxiale.

6. Procédé selon l'une quelconque des revendications 1 à 2 dans lequel l'altération partielle comprend une formation de tranchées de relaxation (42) dans la couche (14) donneuse de contrainte, orientées selon la direction (y) déterminée.

7. Procédé selon la revendication précédente dans lequel les tranchées de relaxation (42) sont séparées par des bandes (41) de couche (14) donneuse de contrainte présentant une largeur l₄₁ environ égale à une moitié de l'épaisseur e₁₄ de la couche (14) donneuse de contrainte.

8. Procédé selon l'une quelconque des revendications précédentes dans lequel l'empilement comprend une couche isolante (12) entre la couche semi-conductrice (13) et la couche fusible (11).

9. Procédé selon l'une quelconque des revendications précédentes dans lequel la couche (14) donneuse de contrainte est à base de nitrure de silicium.

10. Procédé selon l'une quelconque des revendications précédentes dans lequel la fusion est effectuée par recuit thermique de type recuit thermique rapide ou à l'aide d'un laser nanoseconde.

11. Procédé selon l'une quelconque des revendications précédentes dans lequel la couche fusible (11) est amorphe.

12. Procédé selon la revendication précédente dans lequel la couche fusible (11) amorphe est formée par épitaxie avant d'être amorphisée par implantation.

13. Procédé selon l'une quelconque des revendications précédentes dans lequel la couche semi-conductrice (13) est à base de silicium ou de silicium-germanium et la couche fusible (11) est à base de silicium-germanium ou de germanium et présente une teneur en germanium plus élevée que la couche semi-conductrice (13).

14. Procédé de fabrication d'un transistor comprenant la mise en œuvre d'un procédé de réalisation d'un état de contrainte uniaxiale (C3, C3') selon l'une quelconque des revendications précédentes, le transistor comprenant une région de canal réalisée dans ladite couche semi-conductrice (13).

## Patentansprüche

1. Verfahren zur Erzeugung eines einachsigen Spannungszustands (C3, C3') in einer Halbleiterschicht (13),
wobei das Verfahren mindestens Folgendes umfasst:
- Bereitstellen einer Stapelung, die einen Träger (10), die Halbleiterschicht (13) und eine Schmelzschicht (11), die zwischen dem Träger (10) und der Halbleiterschicht (13) eingefügt wird, umfasst,
- Bilden einer Spannungsgeberschicht (14) auf der Halbleiterschicht (13),
- Definition von Strukturen (100) nach dem Bilden der Spannungsgeberschicht (14),
- Bilden ausgehend von den Strukturen (100) von Bereichen (R1), die von Gräben (110) umgeben sind, die sich bis in die Halbleiterschicht (13) erstrecken,
- teilweise Veränderung der Spannungsgeberschicht (14) auf der Ebene der Bereiche (R1), die dazu konfiguriert ist, einen ersten Spannungszustand (C1) der Spannungsgeberschicht (14) derart zu modifizieren, dass ein zweiter Spannungszustand (C2) hauptsächlich entlang einer bestimmten Richtung (y) erhalten wird,
- mindestens teilweise Fusion der Schmelzschicht (11f) derart, dass die Spannungsgeberschicht (14) mindestens zum Teil durch Entspannung den zweiten Spannungszustand (C2, C2') in die Halbleiterschicht (13) derart transferiert, dass die Halbleiterschicht (13) einen einachsigen Spannungszustand (C3) entlang der bestimmten Richtung (y) aufweist.

2. Verfahren nach dem vorstehenden Anspruch, das außerdem ein Füllen der Gräben (110) zum Bilden von Isoliergräben (20) nach Schmelzen der Schmelzschicht (11) und vor einem Entfernen der Spannungsgeberschicht (14) umfasst.

3. Verfahren nach einem der vorstehenden Ansprüche, wobei die teilweise Veränderung eine Ionenimplantation in einem Teil der Spannungsgeberschicht (14) umfasst, die implantierte Bänder (40) bildet, die entlang der bestimmten Richtung (y) ausgerichtet sind, wobei sich die implantierten Bänder (40) auf einer gesamten Abmessung der Spannungsgeberschicht (14) entlang der bestimmten Richtung (y) erstrecken.

4. Verfahren nach dem vorstehenden Anspruch, wobei der erste Spannungszustand (C1) im Wesentlichen gleich null ist und der zweite Spannungszustand (C2) einer einachsigen Kompression entspricht.

5. Verfahren nach Anspruch 3, wobei der erste Spannungszustand (C1) einer zweiachsigen Spannung entspricht und der zweite Spannungszustand (C2) einer einachsigen Spannung entspricht.

6. Verfahren nach einem der Ansprüche 1 bis 2, wobei die teilweise Veränderung ein Bilden von Entspannungsgräben (42) in der Spannungsgeberschicht (14), die entlang der bestimmten Richtung (y) ausgerichtet sind, umfasst.

7. Verfahren nach dem vorstehenden Anspruch, wobei die Entspannungsgräben (42) durch Bänder (41) aus Spannungsgeberschicht (14) getrennt sind, die eine Breite l₄₁ in etwa gleich einer Hälfte der Dicke e₁₄ an der Spannungsgeberschicht (14) aufweisen.

8. Verfahren nach einem der vorstehenden Ansprüche, wobei die Stapelung eine Isolierschicht (12) zwischen der Halbleiterschicht (13) und der Schmelzschicht (11) umfasst.

9. Verfahren nach einem der vorstehenden Ansprüche, wobei die Spannungsgeberschicht (14) auf Siliziumnitrid basiert.

10. Verfahren nach einem der vorstehenden Ansprüche, wobei die Fusion durch Tempern vom Typ schnelles Tempern oder mit Hilfe eines Nanosekundenlasers erfolgt.

11. Verfahren nach einem der vorstehenden Ansprüche, wobei die Schmelzschicht (11) amorph ist.

12. Verfahren nach dem vorstehenden Anspruch, wobei die amorphe Schmelzschicht (11) durch Epitaxie gebildet wird, bevor sie durch Implantation amorphisiert wird.

13. Verfahren nach einem der vorstehenden Ansprüche, wobei die Halbleiterschicht (13) auf Silizium oder Silizium-Germanium basiert und die Schmelzschicht (11) auf Silizium-Germanium oder Germanium basiert und einen höheren Germaniumgehalt als die Halbleiterschicht (13) aufweist.

14. Verfahren zur Erzeugung eines Transistors, das die Umsetzung eines Erzeugungsverfahrens eines einachsigen Spannungszustands (C3, C3') nach einem der vorstehenden Ansprüche umfasst, wobei der Transistor einen Kanalbereich umfasst, der in der Halbleiterschicht (13) hergestellt ist.

## Claims

1. Method for producing a uniaxial stress state (C3, C3') in a semiconductive layer (13),
Said method comprising at least:
- One provision of a stack comprising a support (10), the semiconductive layer (13) and a fuse layer (11) inserted between the support (10) and the semiconductive layer (13),
- A formation of a stress donor layer (14) on the semiconductive layer (13),
- A definition of patterns (100) after formation of the stress donor layer (14),
- A formation, from said patterns (100), of regions (R1) surrounded by trenches (110) extending up to into the semiconductive layer (13),
- A partial alteration of the stress donor layer (14) at said regions (R1), configured to modify a first stress state (C1) of said stress donor layer (14), so as to obtain a second stress state (C2) mainly in a determined direction (y),
- An at least partial melting of the fuse layer (11f), such that the stress donor layer (14) transfers at least partially, by relaxation, the second stress state (C2, C2') in the semiconductive layer (13), such that the semiconductive layer (13) has a uniaxial stress state (C3) in said determined direction (y).

2. Method according to the preceding claim, further comprising a filling of the trenches (110) to form isolating trenches (20), after melting of the fuse layer (11) and before a removal of the stress donor layer (14).

3. Method according to any one of the preceding claims, wherein the partial alteration comprises an ion implantation in a part of the stress donor layer (14) forming implanted strips (40) oriented in the determined direction (y), said implanted strips (40) extending over the entire dimension of the stress donor layer (14) in the determined direction (y).

4. Method according to the preceding claim, wherein the first stress state (C1) is substantially zero and the second stress state (C2) corresponds to a uniaxial compression.

5. Method according to claim 3, wherein the first stress state (C1) corresponds to a biaxial tension and the second stress state (C2) corresponds to a uniaxial tension.

6. Method according to any one of claims 1 to 2, wherein the partial alteration comprises a formation of relaxation trenches (42) in the stress donor layer (14), oriented in the determined direction (y).

7. Method according to the preceding claim, wherein the relaxation trenches (42) are separated by stress donor layer (14) strips (41) having a width l₄₁ around equal to half the thickness e₁₄ of the stress donor layer (14).

8. Method according to any one of the preceding claims, wherein the stack comprises an isolating layer (12) between the semiconductive layer (13) and the fuse layer (11).

9. Method according to any one of the preceding claims, wherein the stress donor layer (14) is silicon nitride-based.

10. Method according to any one of the preceding claims, wherein the melting is performed by thermal annealing of the rapid thermal annealing type or using a nanosecond laser.

11. Method according to any one of the preceding claims, wherein the fuse layer (11) is amorphous.

12. Method according to the preceding claim, wherein the amorphous fuse layer (11) is formed by epitaxy before being amorphised by implantation.

13. Method according to any one of the preceding claims, wherein the semiconductive layer (13) is silicon- or silicon-germanium-based and the fuse layer (11) is silicon-germanium- or germanium-based and has a germanium content which is greater than the semiconductive layer (13).

14. Method for manufacturing a transistor comprising the implementation of a method for producing a uniaxial stress state (C3, C3') according to any one of the preceding claims, the transistor comprising a channel region made in said semiconductive layer (13).
